# EUROPÄISCHE PATENTANMELDUNG

(11) **EP 3 627 564 A1**
(43) Veröffentlichungstag der Anmeldung: **25.03.2020**
(21) Anmeldenummer: 18196125.1
(22) Anmeldetag: 22.09.2018
(51) Int. Cl.: H01L 31/032

(54) **VERFAHREN ZUR NACHBEHANDLUNG EINER ABSORBERSCHICHT**

(71) Anmelder: (CNBM) Bengbu Design & Research Institute for Glass Industry Co., Ltd., 233010 Bengbu (CN)
(72) Erfinder: ALGASINGER, Michael, 81241 München (DE); DALIBOR, Thomas, 82211 Herrsching am Ammersee (DE); PALM, Jörg, 80797 München (DE)
(74) Vertreter: Gebauer, Dieter Edmund

(57) **Zusammenfassung**

Die Erfindung betrifft ein Verfahren zur Nachbehandlung einer Absorberschicht für die fotoelektrische Konversion von einfallendem Licht in elektrischen Strom, welches die folgenden Schritte umfasst: Bereitstellen einer chalkogenhaltigen Absorberschicht auf einem Träger; Aufbringen einer Nachbehandlungssschicht auf eine Oberfläche der Absorberschicht, wobei die Nachbehandlungsschicht mindestens einen Nachbehandlungsstoff, gewählt aus der Gruppe, bestehend aus einem Metallchalkogenid, einer Sauerstoffverbindung eines Metallchalkogenids und einer Hydrogen-Sauerstoffverbindung eines Metallchalkogenids, enthält; thermisches Eindiffundieren des mindestens einen Nachbehandlungsstoffs in die Absorberschicht. Die Erfindung erstreckt sich weiterhin auf ein Verfahren zur Herstellung eines Schichtensystems für die Fertigung von Dünnschichtsolarzellen, bei dem die chalkogenhaltige Absorberschicht einer erfindungsgemäßen Nachbehandlung unterzogen wird.

## Beschreibung

Die vorliegende Erfindung liegt auf dem technischen Gebiet der Herstellung von Dünnschichtsolarzellen und betrifft ein Verfahren zur Nachbehandlung einer Absorberschicht, deren Halbleitermaterial zur Konversion von einfallendem Sonnenlicht in elektrischen Strom dient. Die Erfindung erstreckt sich weiterhin auf die Herstellung eines Schichtensystems für Dünnschichtsolarzellen, bei dem eine solche Nachbehandlung der Absorberschicht erfolgt, sowie generell auf die Verwendung des Verfahrens zur Nachbehandlung einer Absorberschicht bei der Herstellung eines Schichtensystems für Dünnschichtsolarzellen.

Photovoltaische Schichtensysteme für die Fertigung von Dünnschichtsolarzellen sind dem Fachmann beispielsweise durch im Handel verfügbare Solarmodule wohlbekannt. Die Materialien der Schichten, insbesondere das halbleitende Material der zur photoelektrischen Konversion eingesetzten Absorberschicht, werden so gewählt, dass das einfallende Sonnenlicht mit einem zufriedenstellenden Wirkungsgrad in elektrischen Strom umgewandelt werden kann. Aufgrund der physikalischen Eigenschaften und der technologischen Handhabbarkeit sind Absorberschichten aus amorphem, mikromorphem oder polykristallinem Silizium, Cadmium-Tellurid (CdTe), Gallium-Arsenid (GaAs), Kupfer-Indium/Gallium-Diselenid/Disulfid/ Disulfoselenid (Cu(In,Ga)(S,Se)₂), Kupfer-Zink-Zinn-Sulfo-Selenid (CZTS aus der Gruppe der Kesterite) sowie organischen Halbleitern in besonderer Weise für Dünnschichtsolarzellen geeignet. Der pentenäre Halbleiter Cu(In,Ga)(S,Se)₂, der zur Gruppe der Chalkopyrit-Verbindungshalbleiter gehört, hat in der industriellen Serienfertigung von Dünnschichtsolarmodulen besondere Bedeutung erlangt.

Dünnschichtsolarzellen mit einem Absorber auf Basis von Cu(In,Ga)(S,Se)₂ benötigen in aller Regel eine Pufferschicht zwischen dem p-leitenden Absorber und einer n-leitenden Frontelektrode. Bislang wird meist Kadmiumsulfid (CdS) als Pufferschicht verwendet, das einen relativ hohen Wirkungsgrad der Dünnschichtsolarzellen ermöglicht. Der Wirkungsgrad beschreibt das Verhältnis von eingestrahlter Leistung zur erzeugten elektrischen Leistung einer Dünnschichtsolarzelle. Mit CdS-Pufferschichten kann bei Laborzellen auf kleinen Flächen ein Wirkungsgrad von bis zu etwa 23% erreicht werden, wobei der Wirkungsgrad für großflächige Solarmodule geringer ist und typischer Weise zwischen 12% und 18% liegt.

Kadmiumsulfid wird in einem nasschemischen Badprozess (CBD-Prozess, CBD = Chemical Bath Deposition) abgeschieden, was jedoch den Nachteil hat, dass sich der Abscheideprozess nur schwierig in den Prozessablauf der gegenwärtigen Produktion von Cu(In,Ga)(S,Se)₂-Dünnschichtsolarzellen integrieren lässt. Insbesondere muss hierzu das Vakuum gebrochen werden, was die Gefahr unerwünschter Verunreinigungen der Absorberschicht mit sich bringt. Ein weiterer Nachteil der CdS-Pufferschicht besteht darin, dass sie das toxische Schwermetall Kadmium enthält. Dadurch entstehen höhere Produktionskosten, da erhöhte Sicherheitsvorkehrungen im Produktionsprozess getroffen werden müssen, beispielsweise bei der Entsorgung des Abwassers. Zudem kann die Entsorgung des Produkts für den Kunden höhere Kosten verursachen, da der Hersteller je nach örtlicher Gesetzgebung zur Rücknahme, zur Entsorgung oder zum Recycling des Produkts gezwungen werden könnte. Ein weiterer Nachteil von CdS-Pufferschichten liegt darin begründet, dass Kadmiumsulfid ein Halbleiter mit einer direkten elektronischen Bandlücke von etwa 2,4 eV ist, was dazu führt, dass das einfallende Licht nicht unwesentlich absorbiert wird. Das in der Pufferschicht absorbierte Licht geht jedoch für die elektrische Ausbeute im Absorber verloren, da die erzeugten Ladungsträger in der Pufferschicht gleich wieder rekombinieren und es in diesem Bereich des Heteroübergangs und im Puffermaterial viele als Rekombinationszentren wirkende Kristalldefekte gibt. Die Folge ist eine Verringerung des Wirkungsgrads der Dünnschichtsolarzelle.

Es wurden daher verschiedene Alternativen zum Puffer aus Kadmiumsulfid für Absorber aus der Familie der Cu(In,Ga)(S,Se)₂-Halbleiter getestet, beispielsweise gesputtertes ZnMgO, durch CBD abgeschiedenes Zn(S,OH), durch CBD abgeschiedenes In(O,OH) und Indiumsulfid, abgeschieden durch Atomic Layer Deposition (ALD), Ion Layer Gas Deposition (ILGAR), Sprühpyrolyse oder Physical Vapor Deposition (PVD)-Verfahren, wie thermisches Verdampfen oder Sputtern. Allerdings können durch diese Puffermaterialien für Dünnschichtsolarzellen mit einem Absorber auf Basis von Cu(In,Ga)(S,Se)₂ meist nicht die gleichen Wirkungsgrade erreicht werden wie für eine CdS-Pufferschicht und es können weitere Nachteile auftreten.

Speziell bei Puffern auf Basis von InₓS_{y} kann durch Beimischung von Alkalimetallen und/oder Halogeniden eine höhere Bandlücke als bei Puffern auf Basis von CdS erzeugt werden, um die mit einer geringeren Bandlücke verbundenen Nachteile der CdS-Pufferschicht zu vermeiden. Jedoch sind zur Erzielung eines möglichst hohen Wirkungsgrads die Elemente In, S sowie das Alkalimetall und/oder Halogenid in einem relativ engen Einstellbereich zueinander zu kontrollieren, sowohl bezüglich der Homogenität über die gesamte Modulfläche als auch bezüglich der kompletten Zeitdauer eines Verdampfungszyklus in der Produktion. Maßgebend dabei sind das In/(In+S)-Verhältnis sowie das Na/In-Verhältnis. Zudem erhöhen die zum Teil korrosiven Verdampfungsmaterialien oder -produkte die Stillstandszeit von Produktionsanlagen durch den notwendigen Austausch von Komponenten. Ferner steht das optimale Na/In-Verhältnis auch in Abhängigkeit zum Alkali-Gesamthaushalt des CIGSSe-Absorbers. Pufferschichten auf Basis von Indiumsulfid sind beispielsweise aus

WO 2009/141132 A2, WO 107210187, WO 2014/207233 und WO 2014/207226 bekannt.

Weiterhin zeigen von CdS verschiedene Pufferschichten tyischer Weise zu große Instabilitäten, Hystereseeffekte oder Degradationen im Wirkungsgrad, wenn sie Licht, Wärme und/oder Feuchte ausgesetzt sind.

Generell soll mit dem Solarmodul ein möglichst hoher Wirkungsgrad für die Umwandlung von Licht in elektrische Leistung erreicht werden, was voraussetzt, dass die eingesetzte Pufferschicht eine möglichst geringe optische Absorption hat. Der Wirkungsgrad muss möglichst stabil sein, wenn das Bauelement Temperatur, Licht, Feuchte, mechanischer und elektrischer Spannung ausgesetzt wird. Tatsächlich werden bei Solarzellen auf Basis der Chalcopyrite oft Hystereeffekte beobachtet, wobei der Wirkungsgrad durch Einwirkung von Wärme und/oder Feuchte degradieren kann. Durch Beleuchtung kann der Wirkungsgrad teilweise wieder hergestellt werden, jedoch können auch irreversible Verluste zurückbleiben. In manchen Fällen stellt sich der Wirkungsgrad nach Herstellung der Zellen erst durch lange Beleuchtung (Light Soaking) ein.

Im Hinblick auf eine kommerzielle Nutzung von Solarmodulen sollen die Kosten für die Herstellung der Pufferschicht, d.h. Kosten für Anlagen, Material, und Betrieb (Medien, Strom, Entsorgung, Abwasser), möglichst gering sein. Zudem soll der Herstellungsprozess für den Puffer kompatibel mit den übrigen Prozessen sein, und insbesondere darf das darunterliegende Schichtsystem durch den eingesetzten Prozess nicht geschädigt werden.

Die Erfindung zielt auf vorstehende Aufgaben ab. So soll einerseits der Wirkungsgrad von Dünnschichtsolarzellen verbessert werden, um die wirtschaftlich sinnvolle Verwendung von Alternativen zur Pufferschicht aus CdS in der industriellen Serienfertigung von Dünnschichtsolarmodulen zu ermöglichen. Andererseits soll die Herstellung von Dünnschichtmodulen, insbesondere durch die Wahl der eingesetzten Puffermaterialien und Herstellungsverfahren für den Puffer, technisch einfach umsetzbar, kostengünstig und umweltverträglich sein. Diese und weitere Aufgaben werden nach dem Vorschlag der Erfindung durch ein Verfahren zur Nachbehandlung einer Absorberschicht mit den Merkmalen des unabhängigen Patentanspruchs gelöst. Vorteilhafte Ausgestaltungen der Erfindung sind durch die Merkmale der Unteransprüche angegeben.

Erfindungsgemäß ist ein Verfahren zur Nachbehandlung einer Absorberschicht gezeigt, deren Halbleitermaterial für eine (foto-)elektrische Konversion von einfallendem Sonnenlicht in elektrischen Strom dient. Das erfindungsgemäße Verfahren wird vorteilhaft zur Nachbehandlung einer Absorberschicht in einem Verfahren zur Herstellung eines Schichtensystems (Schichtenaufbaus) für die Fertigung von Dünnschichtsolarzellen eingesetzt.

Die nachfolgenden Ausführungen beschreiben Merkmale von Dünnschichtsolarzellen bzw. Dünnschichtsolarmodulen, für welche das erfindungsgemäße Verfahren zur Nachbehandlung von Absorberschichten vorteilhaft eingesetzt werden kann, wobei das erfindungsgemäße Verfahren zur Nachbehandlung von Absorberschichten hierfür auch vorgesehen ist.

Dünnschichtsolarzellen basieren generell auf fotovoltaischen Schichtensystemen mit einer geringen Gesamtdicke von beispielsweise einigen Mikrometern, welche einen Träger für eine ausreichende mechanische Festigkeit benötigen. Der Träger besteht beispielsweise aus Glas, Kunststoff, Keramik, Metall oder einer Metalllegierung und kann in Abhängigkeit von der jeweiligen Trägerdicke und den spezifischen Materialeigenschaften als starre Platte oder biegsame Folie ausgestaltet sein. Glas, insbesondere Kalknatronglas, ist als Trägermaterial bevorzugt. Die Schichtdicke des Trägers liegt beispielsweise im Bereich von 1 mm bis 5 mm. Vorteilhaft handelt es sich um ein Dünnschichtsolarmodul mit Verbundscheibenstruktur, welches über eine transparente Deckplatte (z.B. Glas) und ein rückseitiges Substrat (z.B. Glas) verfügt, die durch eine thermoplastische oder vernetzende Polymer-Zwischenschicht (z.B. PVB oder EVA) fest miteinander verbunden sind. Das Dünnschichtsolarmodul kann eine so genannte "Substratkonfiguration" aufweisen, bei der das Schichtensystem zur Ausbildung der Dünnschichtsolarzellen auf einer lichteintrittsseitigen Oberfläche des rückseitigen Substrats aufgebracht ist. In diesem Fall dient das rückseitige Substrat als Träger für das Schichtensystem. Gleichermaßen kann das Dünnschichtsolarmodul eine so genanne "Superstratkonfiguration" aufweisen, bei welcher das Schichtensystem auf einer von der Lichteintrittsseite abgewandten Oberfläche der frontseitigen Deckplatte aufgebracht ist. In diesem Fall dient die frontseitige Deckplatte als Träger für das Schichtensystem.

Das Schichtensystem für die Herstellung von Dünnschichtsolarzellen umfasst eine Mehrzahl Schichten, die stapelförmig übereinander liegend angeordnet sind. Wenn nicht explizit angegeben, ist im Sinne vorliegender Erfindung die Anordnung einer Schicht "auf" einer anderen Schicht im Schichtensystem nicht so zu verstehen, daß die beiden Schichten unmittelbar aufeinander liegen müssen. Vielmehr können eine oder mehrere weitere Schichten (Zwischenschichten) zwischen diesen beiden Schichten angeordnet sein. In entsprechender Weise muss eine "auf" dem Träger angeordnete Schicht nicht zwingend unmittelbar auf dem Träger angeordnet sein. Der Begriff "Schicht" kann eine Einzellage aus einem selben Material beschreiben, erstreckt sich jedoch auch auf eine Mehrzahl stapelförmig aufeinander angeordneter Einzellagen, wobei zwei unmittelbar benachbarte Einzellagen zur Unterscheidung aus voneinander verschiedenen Materialien bestehen. Als Schicht wird auch eine Einzellage (oder mehreren Einzellagen) bezeichnet, auf der eine elektrisch leitfähige Struktur abgeschieden ist, beispielsweise eine elektrisch nicht leitfähige Einzellage, auf der ein Metallgitter abgeschieden ist, um die Schicht leitfähig zu machen.

In vorliegender Erfindungsbeschreibung werden für die Zusammensetzung einer Schicht relative Stoffmengenanteile (in Atom-%) von Elementen der Schicht angegeben. Die relativen Stoffmengenanteile bestimmter Elemente der Schicht sind jeweils auf die Gesamtstoffmenge aller Elemente der Schicht bezogen. Demnach beschreibt der relative Stoffmengenanteil eines Stoffs den relativen Anteil der Stoffmenge dieses Stoffs an der Summe der Stoffmengen aller Stoffe in der Schicht. Die Summe der relativen Stoffmengenanteile aller Elemente der Schicht ergibt 100 Atom-%. In einer Schicht können fertigungstechnisch nicht vermeidbare Verunreinigungen einen vernachlässigbaren Anteil haben. Möglich ist jedoch auch, dass solche Verunreinigungen einen nicht vernachlässigbaren Anteil haben. Vorzugsweise beträgt die Summe der relativen Stoffmengenanteile von Verunreinigungen einer Schicht maximal 1 Atom-%.

Das Schichtensystem zur Herstellung des Dünnschichtsolarmoduls umfasst in an sich bekannter Weise eine meist opake Rückelektrodenschicht, eine transparente Frontelektrodenschicht, welche den Durchtritt von einfallendem Sonnenlicht ermöglichen muss, und eine zwischen Rück- und Frontelektrodenschicht angeordnete, fotovoltaisch aktive Absorberschicht, deren Halbleitermaterial in den Solarzellen zur fotoelektrischen Konversion des Sonnenlichts in elektrischen Strom dient.

Die optisch transparente Frontelektrodenschicht enthält vorzugsweise mindestens ein transparentes, dotiertes Metalloxid (TCO = Transparent Conductive Oxide), besonders bevorzugt Aluminium-, Gallium- oder Bor-dotiertes Zinkoxid und/oder Indium-Zinnoxid (ITO). Vorzugsweise besteht die Frontelektrodenschicht zu mindestens 95 Atom-%, besonders bevorzugt zu mindestens 99 Atom-%, aus dem mindestens einen dotierten Metalloxid, wobei vorstehende prozentuale Werte die Summe der relativen Stoffmengenanteile der Elemente des transparenten, dotierten Metalloxids angeben. Die Schichtdicke der Frontelektrodenschicht beträgt beispielsweise 100 bis 1500 nm. Denkbar ist auch, dass die Frontelektrodenschicht eine Einzelage aus einem transparenten, elektrisch nicht-leitenden Material aufweist, auf die ein Metallgitter aufgebracht ist, wodurch die Frontelektrodenschicht elektrisch leitfähig wird.

Die typischer Weise opake Rückelektrode enthält beispielsweise mindestens ein Metall, bevorzugt Molybdän (Mo), Aluminium (Al), Kupfer (Cu), Titan (Ti) oder Zink (Zn) oder besteht aus einem Mehrschichtsystem mit einem solchen Metall. Vorzugsweise besteht die Rückelektrodenschicht zu mindestens 95 Atom-%, besonders bevorzugt zu mindestens 99 Atom-%, aus dem mindestens einen Metall. In einer vorteilhaften Ausgestaltung der Rückelektrode weist diese eine Teilschicht aus mindestens einem metallische Material auf, die an die Absorberschicht angrenzt, sowie eine Siliziumnitridteilschicht (SiN), die auf den Träger aufgebracht ist. Derartige Rückelektrodenschichten sind beispielsweise aus EP 1356528 A1 bekannt. Die Schichtdicke der Rückelektrodenschicht ist typischer Weise geringer als 1 pm, liegt beispielsweise im Bereich von 200 nm bis 600 nm und kann insbesondere beispielsweise 400 nm betragen. Die Rückelektrodenschicht dient als Rückseitenkontakt der Solarzellen. Zwischen dem Träger und der Rückelektrode kann eine Alkali-Barriere angeordnet sein, welche beispielsweise aus Si₃N₄, SiON oder SiCN besteht.

Im Sinne vorliegender Erfindung bezieht sich der Begriff "transparent" auf eine Durchlässigkeit für sichtbares Licht und infrarotes Licht von wenigstens 85%, insbesondere wenigstens 90%, vorzugsweise wenigstens 95%, insbesondere 100%. Typischer Weise liegt sichtbares Licht im Wellenlängenbereich von 380 nm bis 780 nm vor, infrarotes Licht erstreckt sich bis 1300 nm. Der Begriff "opak" bezieht sich auf eine Durchlässigkeit für sichtbares und infrarotes Licht von weniger als 5%, insbesondere 0%.

Die Absorberschicht, welche durch das erfindungsgemäße Verfahren nachbehandelt wird, enthält ein chalkogenhaltiges Halbleitermaterial. Als Chalkogene werden die Elemente der 6. Hauptgruppe des Periodensystems bezeichnet. Das Halbleitermaterial der Absorberschicht enthält mindestens ein Chalkogen, vorzugsweise Schwefel und/oder Selen.

Vorzugsweise enthält die Absorberschicht einen chalkogenhaltigen Chalkopyrit-Verbindungshalbleiter, bei dem es sich besonders bevorzugt um einen ternären I-III-VI-Verbindungshalbleiter aus der Gruppe Kupfer-Indium/Gallium-Disulfid/Diselenid handelt, abgekürzt durch die Formel Cu(In,Ga)(S,Se)₂. In vorstehender Formel können Indium und Gallium jeweils allein oder in Kombination vorliegen. Entsprechendes gilt für die Chalkogene Schwefel und Selen, die jeweils allein oder in Kombination vorliegen können. Der chalkogenhaltige Chalkopyrit-Verbindungshalbleiter enthält mindestens ein Chalkogen, vorzugsweise Schwefel und/oder Selen. Als Material für die Absorberschicht eignet sich in besonderer Weise CISe (Kupfer-Indium-Diselenid), CIS (Kupfer-Indium-Disulfid), CIGSe (Kupfer-Indium-Gallium-Diselenid) CIGS (Kupfer-Indium-Gallium-Disulfid) oder CIGSSe (Kupfer-Indium-Gallium-Disulfoselenid).

Gleichermaßen bevorzugt enthält die Absorberschicht einen chalkogenhaltigen Kesterit-Verbindungshalbleiter, vorzugsweise Kupfer-Zink-Zinn-Sulfoselenid (CZTS). Der chalkogenhaltige Kesterit-Verbindungshalbleiter enthält mindestens ein Chalkogen, vorzugsweise Schwefel und/oder Selen.

Zweckmäßig wird eine Cu(In,Ga)(S,Se)₂-Absorberschicht in einem zweistufigen RTP-Prozess (RTP = rapid thermal processing) hergestellt. Hierbei wird, nach Herstellen einer Rückelektrodenschicht auf dem Träger, zunächst eine Vorläuferschicht (Precursor) auf die Rückelektrodenschicht aufgebracht. Die Vorläuferschicht, welche aus mehreren Einzellagen bestehen kann, enthält die Elemente Kupfer, Indium und Gallium, die vorzugsweise durch Sputtern aufgebracht werden. Des Weiteren enthält die Vorläuferschicht mindestens ein Chalkogen in elementarer Form, vorzugsweise Selen und/oder Schwefel, welches vorzugsweise durch thermisches Verdampfen aufgebracht wird. Bei diesen Abscheideprozessen liegt die Temperatur des Trägers typischer Weise unterhalb von 100°C, so dass die Elemente im Wesentlichen als Metalllegierung und elementares Chalkogen (Selen und/oder Schwefel) unreagiert erhalten bleiben. Anschließend wird die Vorläuferschicht durch Erwärmen in einer mindestens ein Chalkogen (Selen und/oder Schwefel) enthaltenden Atmosphäre zu einem Cu(In,Ga)(S,Se)₂-Verbindungshalbleiter reagiert (thermisch umgesetzt). Beispielsweise enthält die Vorläuferschicht als Chalkogen nur elementares Selen und die thermische Umsetzung der Vorläuferschicht erfolgt in einer Atmosphäre, die als Chalkogen nur Schwefel enthält. Durch die Wärmebehandlung der Vorläuferschicht findet eine Kristallbildung und Phasenumwandlung der Vorläuferschicht zur eigentlichen Halbleiterschicht (Verbindungshalbleiter) statt. Ein solches zweistufiges Verfahren ist beispielsweise aus J. Palm et al., "CIS module pilot processing applying concurrent rapid selenization and sulfurization of large area thin film precursors", Thin Solid Films 431-432, S. 414-522 (2003) bekannt. In entsprechender Weise kann in einem zweistufigen Verfahren ein chalkogenhaltiger Kesterit-Verbindungshalbleiter hergestellt werden, wobei zunächst eine Vorläuferschicht auf die Rückelektrodenschicht aufgebracht wird, die Kupfer, Zink, Zinn und mindestens ein Chalkogen (vorzugsweise Schwefel und/oder Selen, besonders bevorzugt nur Selen) enthält. Anschließend wird die Vorläuferschicht durch Erwärmen in einer Atmosphäre, welche mindestens ein Chalkogen (vorzugsweise Schwefel und/oder Selen, besonders bevorzugt nur Schwefel) enthält, zum Verbindungshalbleiter umgesetzt. Vorzugsweise besteht die Absorberschicht zu mindestens 80 Atom-%, insbesondere zu mindestens 90 Atom-%, insbesondere zu mindestens 95 Atom-%, aus dem chalkogenhaltigen Halbleitermaterial, wobei vorstehende prozentuale Werte die Summe der relativen Stoffmengenanteile der Elemente des chalkogenhaltigen Halbleitermaterials angeben. Die chalkogenhaltige Absorberschicht enthält weitere Elemente mindestens eines Nachbehandlungsstoffs (PDT-Stoff, PDT = Post Deposition Treatment) der nachfolgend beschriebenen Nachbehandlungsschicht (PDT-Schicht), deren relative Stoffmengenanteile in der Absorberschicht weiter unten angegeben sind. Vorzugsweise enthält die Absorberschicht keine weiteren Elemente als jene des chalkogenhaltigen Halbleitermaterials und des mindestens einen Nachbehandlungsstoffs, wobei vorzugsweise fertigungstechnisch gegebenenfalls nicht vermeidbare Verunreinigungen in Summe einen relativen Stoffmengenanteil haben, der maximal 1 Atom-% beträgt.

Das Halbleitermaterial der Absorberschicht weist eine Dotierung von einem ersten Leitungstyp (Ladungsträgertyp) und die Frontelektrode eine Dotierung vom entgegengesetzten Leitungstyp (Ladungsträgertyp) auf. Typischer Weise ist die Absorberschicht p-leitend (p-dotiert), verfügt also über einen Überschuss an Defektelektronen (Löcher), und die Frontelektrodenschicht ist n-leitend (n-dotiert), so dass freie Elektronen in Überschuß vorhanden sind.

Zwischen Absorberschicht und Frontelektrodenschicht ist mindestens eine Pufferschicht angeordnet. Die Pufferschicht kann verschiedene Puffermaterialien enthalten, insbesondere Zinkoxisulfid Zn(O,S), Zinkoxihydrogensulfid Zn(O,OH,S), Kadmiumsulfid CdS, Indiumsulfid InₓS_{y} und Zinkmagnesiumoxid Zn₁₋ₓMgₓO. Beispielsweise besteht die Pufferschicht aus einer Einzellage aus mit Natrium dotiertem Indiumsulfid (In₂S₃:Na) und einer Einzellage aus (nichtdotiertem) intrinsischem Zink-oxid (i-ZnO). Besonders bevorzugt basiert die Pufferschicht auf Zn und enthält Zinkoxisulfid Zn(O,S) oder Zinkoxihydrogensulfid Zn(O,OH,S).

Vorzugsweise besteht die Pufferschicht zu mindestens 95 Atom-%, insbesondere zu mindestens 99 Atom-%, aus dem jeweils angegebenen Puffer, wobei vorstehende prozentuale Werte die Summe der relativen Stoffmengenanteile der Elemente des Puffers angeben. Vorzugsweise enthält die Pufferschicht keine weiteren Elemente als jene des jeweils angegeben Puffers, wobei fertigungstechnisch gegebenenfalls nicht vermeidbare relative Stoffmengenanteile an hiervon verschiedenen, weiteren Elementen (Verunreinigungen) in Summe vorzugsweise maximal 1 Atom-% betragen.

Das Schichtensystem weist somit, stapelförmig übereinander angeordnet, eine Rückelektrodenschicht, eine Absorberschicht, mindestens eine Pufferschicht und eine Frontelektrodenschicht auf. Für die Abscheidung der verschiedenen Schichten sind prinzipiell alle chemisch-physikalischen Abscheidungsverfahren geeignet.

Durch Strukturierungslinien werden serienverschaltete Solarzellen im Schichtensystem ausgebildet. So ist mindestens die Rückelektrodenschicht durch erste Strukturierungslinien (P1-Linien) in voneinander getrennte Abschnitte unterteilt, welche die Rückelektroden der Solarzellen bilden. Ferner ist mindestens die Absorberschicht durch zweite Strukturierungslinien (P2-Linien) in voneinander getrennte Abschnitte unterteilt, welche die Absorber der Solarzellen bilden, und mindestens die Frontelektrodenschicht ist durch dritte Strukturierungslinien (P3-Linien) in voneinander getrennte Abschnitte unterteilt, welche die Frontelektroden der Solarzellen bilden. Benachbarte Solarzellen sind über elektrisch leitfähiges Material in den zweiten Strukturierungslinien in Serienverschaltung elektrisch miteinander verbunden, wobei die Frontelektrode einer Solarzelle mit der Rückelektrode der benachbarten Solarzelle elektrisch verbunden ist und mit dieser typischer Weise, jedoch nicht zwingend, direkten Berührungskontakt hat. Jede Strukturierungszone umfasst eine unmittelbare Abfolge der drei Strukturierungslinien P1-P2-P3, jeweils in dieser Reihenfolge. In Einklang mit der gängigen Verwendung bezieht sich der Begriff "Solarzelle" auf einen Bereich des Schichtensystems, der eine Frontelektrode, einen fotovoltaisch aktiven Absorber und eine Rückelektrode aufweist und von zwei einander unmittelbar benachbarten Strukturierungszonen begrenzt wird. Im Randbereich des Moduls gilt dies analog, wobei anstelle einer Strukturierungszone ein Anschlussabschnitt für eine elektrische Kontaktierung der Serienverschaltung der Solarzellen vorhanden ist.

Das erfindungsgemäße Verfahren für die Nachbehandlung einer chalkogenhaltigen Absorberschicht umfasst zunächst das Bereitstellen einer chalkogenhaltigen Absorberschicht auf einem Träger. Die chalkogenhaltige Absorberschicht und der Träger können insbesondere wie vorstehend ausgeführt ausgebildet sein. Vorzugsweise enthält die Absorberschicht einen chalkogenhaltigen Chalkopyrit-Verbindungshalbleiter oder einen chalkogenhaltigen Kesterit-Verbindungshalbleiter, wobei die Kristallbildung des Halbleitermaterials bereits vollständig abgeschlossen ist. Mit anderen Worten, ein Halbleitermaterial, das auf einem Chalkopyrit- oder Kesterit-Verbindungshalbleiter basiert, ist durch Erwärmen bereits vollständig zum Verbindungshalbleiter reagiert, so dass die Kristallbildung (und Phasenumwandlung) abgeschlossen ist.

Anschließend wird auf eine Oberfläche der Absorberschicht (die vom Träger abgewandte freiliegende Oberfläche der Absorberschicht) eine zur Nachbehandlung der Absorberschicht dienende Schicht, im Weiteren als "Nachbehandlungsschicht" bezeichnet, aufgebracht. Die Nachbehandlungsschicht enthält mindestens einen Stoff, im Weiteren als "Nachbehandlungsstoff" bezeichnet, der aus der Gruppe von Nachbehandlungsstoffen, bestehend aus einem Metallchalkogenid, einer Sauerstoffverbindung eines Metallchalkogenids und einer Hydrogen-Sauerstoffverbindung eines Metallchalkogenids, insbesondere der Oxidationsstufen IV oder VI, gewählt ist. Vorteilhafte Nachbehandlungsstoffe sind MetₓCh, MetₓHChO₃, MetₓChO₃, MetₓHChO₄ und MetₓChO₄, wobei "Met" das Metall und "Ch" das Chalkogen in der jeweiligen Oxidationsstufe angibt. Die Nachbehandlungsschicht wird unmittelbar (d.h. ohne Zwischenschicht) auf die Absorberschicht abgeschieden.

Bei einer Ausgestaltung der Erfindung wird zur Herstellung der Nachbehandlungsschicht genau ein Nachbehandlungsstoff mit genau einem Alkalichalkogenid, genau einer Sauerstoffverbindung eines Alkalichalkogenids oder genau einer Hydrogen-Sauerstoffverbindung eines Alkalichalkogenids auf die Absorberschicht aufgebracht. In diesem Fall ist im Nachbehandlungsstoff genau ein Alkalielement (nicht mehrere Alkalielemente) chemisch gebunden.

Die Nachbehandlungsschicht bzw. der mindestens eine Nachbehandlungsstoff wird durch ein physikalisches oder chemisches Abscheideverfahren auf der Absorberschicht abgeschieden, vorzugsweise durch thermisches Verdampfen, nasschemische Badabscheidung, Elektronenstrahlverdampfung, Sputtern, Atomic Layer Disposition oder Sprühpyrolyse.

Vorteilhaft ist der mindestens eine Nachbehandlungsstoff aus der Gruppe von Nachbehandlungsstoffen gewählt, die aus einem Alkalisulfid, insbesondere Na₂S, K₂S, Rb₂S, Cs₂S, einem Erdalkalisulfid insbesondere MgS, CaS, einer Hydrogen-Sauerstoffverbindung eines Metallchalkogenids mit der Oxidationsstufe IV, insbesondere NaHSO₃, KHSO₃, RbHSO₃, CsHSO₃, einer Sauerstoffverbindung eines Metallchalkogenids mit der Oxidationsstufe IV, insbesondere Na₂SO₃, K₂SO₃, Rb₂SO₃, Cs₂SO₃, einer Hydrogen-Sauerstoffverbindung eines Metallchalkogenids mit der Oxidationsstufe VI, insbesondere NaHSO₄, KHSO₄, RbHSO₄, CsHSO₄, und einer Sauerstoffverbindung eines Metallchalkogenids mit der Oxidationsstufe VI, insbesondere Na₂SO₄, K₂SO₄, Rb₂SO₄, Cs₂SO₄, besteht.

Vorzugsweise besteht die Nachbehandlungsschicht zu mindestens 95 Atom-%, vorzugsweise zu mindestens 99 Atom-%, aus dem mindestens einen Nachbehandlungsstoff, wobei vorstehende prozentuale Werte die Summe der relativen Stoffmengenanteile der Elemente des mindestens einen Nachbehandlungsstoffes angeben. Vorzugsweise enthält die Nachbehandlungsschicht keine weiteren Elemente als jene des mindestens einen Nachbehandlungsstoffes, wobei fertigungstechnisch gegebenenfalls nicht vermeidbare relative Stoffmengenanteile an hiervon verschiedenen, weiteren Elementen (Verunreinigungen) in Summe vorzugsweise maximal 1 Atom-% betragen.

Der auf die Absorberschicht aufgebrachte mindestens eine Nachbehandlungsstoff der Nachbehandlungsschicht wird in die Absorberschicht thermisch eindiffundiert. Das Eindiffundieren des Nachbehandlungsstoffes in die Absorberschicht erfolgt durch Temperaturerhöhung (Tempern) der Nachbehandlungsschicht, die zu diesem Zweck durch externe Energiezufuhr erwärmt wird.

Gemäß einer Ausgestaltung der Erfindung, bei der sich die Nachbehandlungsschicht im thermischen Gleichgewicht mit dem Träger befindet (d.h. die Temperaturen von Nachbehandlungsschicht und Träger sind zumindest annähernd gleich), wird die Nachbehandlungsschicht zu diesem Zweck auf eine Temperatur im Bereich von 70°C bis 700°C, vorzugsweise 150°C bis 700°C, vorzugsweise für eine Heizdauer im Bereich von 1 min bis 120 min, aufgeheizt.

Gemäß einer weiteren Ausgestaltung der Erfindung, bei der sich die Nachbehandlungsschicht nicht im thermischen Gleichgewicht mit dem Träger befindet (d.h. die Temperaturen von Nachbehandlungsschicht und Träger sind wesentlich verschieden), wird die Nachbehandlungsschicht durch Heizpulse aufgeheizt, wobei der Energieeintrag im Bereich von 0,5 J/cm² bis 15 J/cm² (bezogen auf die Fläche der Nachbehandlungsschicht) liegt, vorzugsweise bei einer Pulsdauer der Heizpulse im Bereich von 0,2 msec bis 20 msec. Die Heizpulse werden vorteilhaft durch eine Blitzlampe oder einen Laser erzeugt.

Gemäß einer weiteren Ausgestaltung der Erfindung wird die Nachbehandlungsschicht auf einen Träger abgeschieden, dessen Temperatur im Bereich von 300°C bis 800°C liegt. Bei der Verwendung eines Chalkopyrit- oder Kesterit-Verbindungshalbleiters kann der Träger insbesondere durch die vorherige thermische Umsetzung der Vorläuferschicht zum Verbindungshalbleiter noch eine hohe Temperatur aufweisen. Die Nachbehandlungsschicht wird entsprechend zeitnah nach Kristallbildung des Verbindungshalbleiters auf die Absorberschicht aufgebracht. In diesem Fall wird die Nachbehandlungsschicht bereits durch den heißen Träger auf eine solche Temperatur aufgeheizt, dass ein hinreichendes Eindiffundieren des mindestens einen Nachbehandlungsstoffes in die Absorberschicht bewirkt wird. Vorteilhaft ist kein weiteres Aufheizen des Trägers erforderlich. Möglich ist jedoch auch, dass der Nachbehandlungsschicht auf dem heißen Träger ergänzend Energie zugeführt wird, beispielsweise um eine hohe Temperatur der Nachbehandlungsschicht (und des Trägers) zu halten und eine passive Abkühlung zu vermeiden oder die Temperatur der Nachbehandlungsschicht noch weiter zu erhöhen.

Erfindungsgemäß kann durch den alleinigen Einsatz mindestens eines Nachbehandlungsstoffes, vorzugsweise Metallchalkogeniden, speziell Alkalisulfiden, in vorteilhafter Weise sowohl eine Passivierung der Absorberschicht durch das Alkalimetall als auch eine Oberflächenterminierung der Absorberschicht durch das Chalkogen erreicht werden. Insbesondere erfolgt eine Passivierung von Korngrenzen und/oder von elektrisch aktiven Defekten durch die Anlagerung des Alkalimetalls. Zudem kann eine Vergrößerung der Oberflächenbandlücke des Halbleitermaterials erreicht werden, wodurch eine elektronische Bandanpassung zwischen Absorberschicht und Pufferschicht optimiert und die Ladungsträgerrekombination reduziert wird. In der Folge kann eine Verringerung der Ladungsträgerrekombination an der Grenzfläche Pufferschicht-Absorberschicht sowie in der Raumladungszone der Absorberschicht erreicht werden. Der Nachbehandlungsstoff hat somit eine Doppelfunktion, die sehr vorteilhafte Effekte mit sich bringt, wie aus verschiedenen Solarparametern ersichtlich ist. So kann für die Solarzellen der Wirkungsgrad verbessert, die offene Klemmspannung vergrößert und der Füllfaktor verbessert werden. Außerdem hat sich gezeigt, dass bei einer Absorberschicht, die erfindungsgemäß nachbehandelt wurde, die Schichtdicke der Pufferschicht verringert werden kann, was in vorteilhafter Weise mit einer Steigerung der Kurzschlussstromdichte durch eine geringere Absorption des einfallenden Sonnenlichts in der Pufferschicht einhergeht.

Vorzugsweise weist die Absorberschicht nach dem thermisch induzierten Eindiffundieren des mindestens einen Nachbehandlungsstoffs in die Absorberschicht einen Stoffmengenanteil an Metall des Nachbehandlungsstoffs im Bereich von 0,02 Atom-% bis 2,5 Atom-%, insbesondere bevorzugt im Bereich 0,1 Atom-% bis 1,3 Atom-%, bezogen auf die Gesamtstoffmenge der Absorberschicht, auf. Hierdurch können die verschiedenen Solarparameter, insbesondere der Wirkungsgrad, besonders gut verbessert werden.

Wie bereits ausgeführt, wird durch den mindestens einen Nachbehandlungsstoff der Absorberschicht ein Chalkogen zugeführt. Somit kann das Eindiffundieren des mindestens einen Nachbehandlungsstoffs in die Absorberschicht grundsätzlich in einer chalkogenfreien Atmosphäre erfolgen, welche beispielsweise aus Inertgas besteht.

Gemäß einer alternativen Ausgestaltung des erfindungsgemäßen Verfahrens erfolgt das thermisch induzierte Eindiffundieren des mindestens einen Nachbehandlungsstoffs in die Absorberschicht in einer mindestens ein Chalkogen enthaltenden Atmosphäre, wodurch die in die Absorberschicht eindiffundierende Chalkogenmenge weiter erhöht werden kann, ohne zugleich die Menge an Alkalimetall zu erhöhen. Die beiden Effekte Passivierung durch das Alkalimetall und Oberflächenterminierung durch das Chalkogen können somit auch unabhängig voneinander gesteuert werden, wobei die Effekte der Oberfächenterminierung selektiv weiter erhöht werden können.

Das Eindiffundieren des mindestens einen Nachbehandlungsstoffs in die Absorberschicht in einer chalcokenhaltigen Atmosphäre oder in einer chalcokenfreien Atmosphäre, insbesondere Inertgas, erfolgt beispielsweise dann, wenn die Nachbehandlungsschicht auf ein heißes Substrat (Träger mit Absorberschicht) mit einer Temperatur im Bereich von 300°C bis 700°C aufgebracht wird.

Der mindestens eine Nachbehandlungsstoff kann beispielsweise auch unter Atmosphärendruck in die Absorberschicht thermisch eindiffundiert werden. Bei einer vorteilhaften Ausführungsform des erfindungsgemäßen Verfahrens erfolgt das Eindiffundieren des mindestens einen Nachbehandlungsstoffs in die Absorberschicht in einer evakuierten Umgebung, was den Vorteil hat, dass unerwünschte Verunreinigungen der Absorberschicht durch die umgebende Atmosphäre vermieden werden können.

Bei einer weiteren vorteihaften Ausführungsform des erfindungsgemäßen Verfahrens wird die Oberfläche der Absorberschicht nach dem Eindiffundieren des Nachbehandlungsstoffs in die Absorberschicht durch physikalische und/oder chemische, trockene und/oder nasse Reinigungsprozesse, insbesondere durch Spülen mit einem gasförmigen oder flüssigen Fluid und/oder Bestrahlen mit UV-Licht und/oder mittels Plasma gereinigt. Mögliche Reinigungsverfahren sind beispielsweise Spülen mit entionisiertem Wasser, Spülen in sauren Lösungen, Spülen in basischen Lösungen, trockene UV-Reinigung, trockene UV-Reinigung mit Ozon und Plasmareinigung. Für die Reinigung der Oberfläche der Absorberschicht können ein oder mehrere Reinigungsverfahren eingesetzt werden. Wie Versuche der Erfinder gezeigt haben, können die beschriebenen vorteilhaften Effekte durch diese Maßnahme noch weiter verbessert werden, wie sich auch aus den Solarparametern ergibt. Insbesondere können durch die Oberflächenreinigung nicht eindiffundierte Rückstände der Nachbehandlungsschicht auf der Oberfläche der Absorberschicht entfernt werden.

Die Erfindung erstreckt sich weiterhin auf ein Verfahren zur Herstellung eines Schichtensystems für die Fertigung von Dünnschichtsolarzellen, welches umfasst:
- Bereitstellen eines Trägers,
- Herstellen einer Rückelektrodenschicht auf dem Träger,
- Herstellen einer chalkogenhaltigen Absorberschicht,
- Herstellen mindestens einer Pufferschicht auf der chalkogenhaltigen Absorberschicht,
- Herstellen einer Frontelektrodenschicht auf der Pufferschicht,
wobei die chalkogenhaltige Absorberschicht gemäß dem vorstehenden erfindungsgemäßen Verfahren nachbehandelt wird.

Die Komponenten des Schichtensystems können wie vorstehend für Dünnschichtsolarzellen beschrieben hergestellt werden. Insbesondere kann die Pufferschicht durch nasschemische Badabscheidung (CBD), Atomic Layer Deposition (ALD), Ion Layer Gas Deposition (ILGAR), Sprühpyrolyse, Chemical Vapor Deposition (CVD) oder Physical Vapor Deposition (PVD) auf die Absorberschicht aufgebracht werden. Vorzugsweise wird die Pufferschicht unmittelbar, d.h. ohne Zwischenschicht auf die erfindungsgemäß nachbehandelte Absorberschicht abgeschieden.

Vorzugsweise enthält die Pufferschicht:
- Zinkoxisulfid, Zn(O,S), mit allen Abscheideverfahren, vorzugsweise Sputtern mit allen Kompositionen an S/(S+O);
- Zinkoxihydrogensulfid Zn(O,OH,S), mit CBD-Abscheideverfahren;
- Kadmiumsulfid, CdS, mit allen Abscheideverfahren;
- Indiumsulfid, InₓS_{y}, mit allen Abscheideverfahren;
- Zinkmagnesiumoxid, Zn₁₋ₓMgₓO, mit allen Abscheideverfahren.

Die Pufferschicht kann durch ein physikalisches oder chemisches Abscheideverfahren hergestellt werden, gemäß einer besonders vorteihaften Ausführungsform des erfindungsgemäßen Verfahrens die Pufferschicht in einer evakuierten Umgebung, beispielsweise durch Sputtern (Kathodenzerstäubung), thermisches Verdampfen oder Elektronenstrahlverdampfen abgeschieden wird. Das Abscheiden der Pufferschicht mit einem Vakuumverfahren hat den besonderen Vorteil, dass im Vakuum der Einbau von Hydroxid oder zusätzlichem Sauerstoff in die Pufferschicht verhindert wird. Hydroxid-Komponenten in der Pufferschicht sind vermutlich verantwortlich für Transienten des Wirkungsgrades bei Einwirkung von Wärme und Licht. Des Weiteren haben Vakuumverfahren den Vorteil, dass das Verfahren ohne Nasschemie auskommt und Standard-Vakuumbeschichtungsanlagen verwendet werden können. Durch die Verwendung eines Vakuumverfahrens wird insbesondere eine mögliche oberflächliche Ga-Verarmung einer Cu(In,Ga)(S,Se)₂-Absorberschicht durch Abscheiden einer Pufferschicht mittels chemischer Badabscheidung (CBD) vermieden. Besonders vorteilhaft wird eine Pufferschicht, enthaltend Zinkoxisulfid, Zn(O,S), durch Sputtern auf die Absorberschicht aufgebracht.

Des Weiteren erstreckt sich die Erfindung auf die Verwendung des erfindungsgemäßen Verfahrens zur Nachbehandlung einer Absorberschicht bei der Herstellung eines Schichtensystems für die Fertigung von Dünnschichtsolarzellen.

Die verschiedenen Ausgestaltungen der Erfindung können einzeln oder in beliebigen Kombinationen realisiert sein. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

### Kurze Beschreibung der Zeichnungen

Die Erfindung wird nun näher erläutert, wobei Bezug auf die beigefügten Figuren genommen wird. Es zeigen:
- Fig. 1: Diagramme, in denen relative Solarparameter für Solarzellen mit verschiedenen Zn(O,S)-Pufferschichten ohne erfindungsgemäße Nachbehandlung der Absorberschicht dargestellt sind;
- Fig. 2: Diagramme, in denen relative Solarparameter für Solarzellen mit unterschiedlich nachbehandelten Absorberschichten mit Zn(O,S)-Puffer, mit und ohne Spülen der Absorberschicht, dargestellt sind;
- Fig. 3: ein Diagramm, in dem die Änderung der mittleren Ladungsträgerlebensdauer nach Aufbringen der Zn(O,S)-Pufferschicht auf die Absorberschicht für verschiedene Na-Mengen und verschiedene Nachbehandlungstemperaturen dargestellt ist;
- Fig. 4: Diagramme, in denen relative Solarparameter für Solarzellen mit unterschiedlich nachbehandelten Absorberschichten mit Zn(O,S)-Puffer für verschiedene Na-Mengen und verschiedene Nachbehandlungstemperaturen dargestellt sind;
- Fig. 5: ein Diagramm, in dem der relative Wirkungsgrad von Solarzellen in Abhängigkeit der NaMenge für verschiedene Nachbehandlungstemperaturen sowie mit und ohne Spülen der Absorberschicht dargestellt ist;
- Fig. 6: Diagramme, in denen relative Sekundärsolarparameter (Sättigungsstromdichte J0 und Diodenidealitätsfaktor n) für Solarzellen mit Zn(O,S)-Puffer ohne und mit erfindungsgemäßer Nachbehandlung der Absorberschicht für verschiedene Na-Mengen und verschiedene Nachbehandlungstemperaturen dargestellt sind;
- Fig. 7: ein Diagramm, in dem TOF-SIMS Na-Profile von Pufferschicht und Absorberschicht ohne und mit erfindungsgemäßer Nachbehandlung der Absorberschicht für verschiedene Na-Mengen und verschiedene Nachbehandlungstemperaturen dargestellt sind;
- Fig. 8: ein Diagramm, in dem ein Oberflächen-S-korreliertes Raman-Signal für CIGSSe-Absorberoberflächen ohne Oberflächenreinigung dargestellt ist;
- Fig. 9: ein Diagramm, in dem ein CIG-korreliertes Raman-Signal für CIGSSe-Absorberoberflächen ohne Oberflächenreinigung dargestellt ist;
- Fig. 10: ein Diagramm, in dem eine Reflektometrie-Auswertung für CIGSSe-Absorberoberflächen ohne Oberflächenreinigung dargestellt ist;
- Fig. 11: ein Diagramm, in dem ein Oberflächen-S-korreliertes Raman-Signal für CIGSSe-Absorberoberflächen mit Oberflächenreinigung dargestellt ist;
- Fig. 12: ein Diagramm, in dem ein CIG-korreliertes Raman-Signal für CIGSSe-Absorberoberflächen mit Oberflächenreinigung dargestellt ist;
- Fig. 13: ein Diagramm, in dem eine Reflektometrie-Auswertung für CIGSSe-Absorberoberflächen mit Oberflächenreinigung dargestellt ist;
- Fig. 14: ein Flussdiagramm zur Veranschaulichung der Verfahrensschritte des erfindungsgemäßen Verfahrens zum Nachbehandeln einer Absorberschicht;
- Fig. 15: ein Flussdiagramm zur Veranschaulichung der Verfahrensschritte des erfindungsgemäßen Verfahrens zum Herstellen eines Schichtensystems für die Fertigung von Dünnschichtsolarzellen, bei dem ein erfindungsgemäßes Nachbehandeln der Absorberschicht erfolgt.

Ausführliche Beschreibung der Zeichnungen

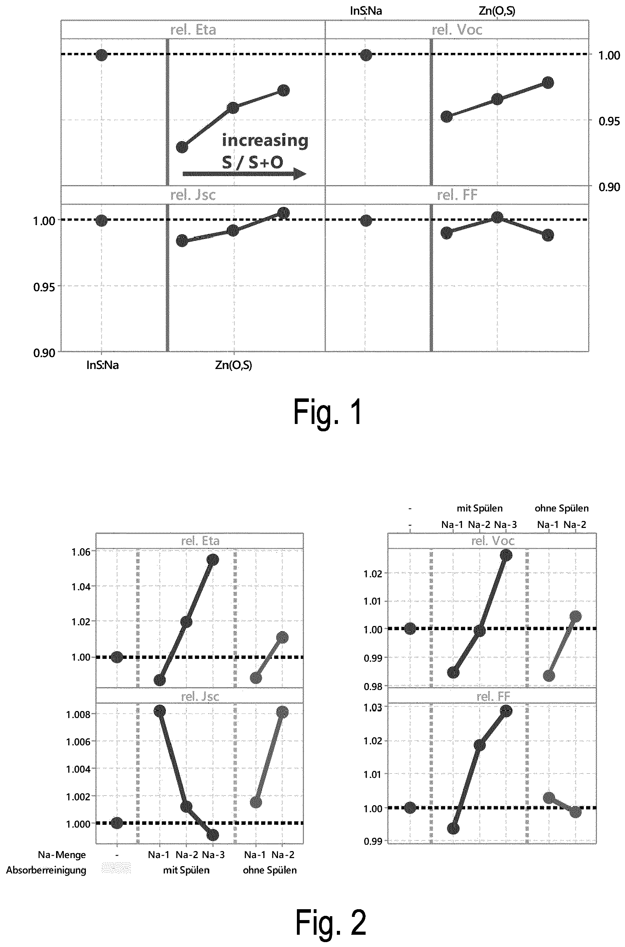

Für die nachfolgend beschriebenen Versuche, deren Ergebnisse anhand von Diagrammen dargestellt sind, wurden Dünnschichtsolarzellen bzw. Dünnschichtsolarmodule hergestellt, die auf einem Schichtensystem mit den folgenden Schichten basierten:
Auf einen Träger aus Glas wurde eine Rückelektrodenschicht aus Molybdän (Mo) aufgebracht. Auf der Rückelektrodenschicht wurde eine CIGSSe-Absorberschicht hergestellt (durch Abscheiden einer Vorläuferschicht, enthaltend Kupfer, Indium, Gallium, Se und thermisches Umsetzen der Vorläuferschicht in einem RTP-Verfahren zum Verbindungshalbleiter in einer S-haltigen Atmosphäre). Auf die CIGSSe-Absorberschicht wurde eine Pufferschicht abgeschieden. In den Schichtensystemen für eine Nachbehandlung gemäß vorliegender Erfindung (Figuren 2 bis 13) wurde eine durch Sputtern auf der CIGSSe-Absorberschicht abgeschiedene Zinkoxisulfid-Pufferschicht, abgekürzt Zn(O,S), insbesondere eine Mischung aus ZnO/ZnS, verwendet. Auf der Pufferschicht wurde eine Frontelektrodenschicht aus Aluminium-dotiertem Zinkoxid (ZnO) abgeschieden. Für eine Nachbehandlung der CIGSSe-Absorberschicht wurde ein Metallchalkogenid, speziell ein Alkalisulfid (hier beispielsweise Natriumsulfid, Na₂S), verwendet, das auf die CIGSSe-Absorberschicht nach dessen Kristallbildung abgeschieden wurde. Das Eindiffundieren des Natriumsulfids in die CIGSSe-Absorberschicht erfolgte in einem Ofen bei einer Temperatur im Bereich von 300°, wobei das Trägerglas in thermischem Gleichgewicht mit der Nachbehandlungsschicht war. Gegebenenfalls wurde die Oberfläche der CIGSSe-Absorberschicht vor dem Abscheiden der Pufferschicht gereinigt (hier beispielsweise durch Spülen mit entionisiertem Wasser).

Sei zunächst Figur 1 betrachtet, die Stand der Technik beschreibt. Bislang hat sich gezeigt, dass der Wirkungsgrad von Dünnschichtsolarzellen mit einer Zn(O,S)-Pufferschicht stets kleiner ist als der mit einer InₓS_{y}-Pufferschicht. Mit dem Ziel diese Wirkungsgradverminderung zu vermeiden, wurden in Figur 1 drei verschiedene S/(S+O)-Verhältnisse der Zn(O,S)-Pufferschicht getestet.

In Figur 1 sind anhand von vier Diagrammen die relativen Solarparameter relativer Wirkungsgrad Eta, relative offene Klemmspannung Voc, relative Kurzschlussstromdichte Jsc und relativer Füllfaktor FF von Solarzellen mit verschiedenen Zn(O,S)-Pufferschichten, jeweils bezogen auf eine Na-dotierte InS-Pufferschicht, dargestellt. Die Cu(In,Ga) (S,Se)₂-Absorberschicht wurde keiner erfindungsgemäßen Nachbehandlung unterzogen. Die Zn(O,S)-Pufferschichten unterschieden sich durch die verschiedenen S/(S+O)-Anteile, wobei der Anteil an S/(S+O) von links nach rechts zunimmt. Die Werte für die Solarparameter der Solarzelle mit der Na-dotierten InₓS_{y}-Pufferschicht dienten als Referenz und sind in jedem Diagramm als horizontale Linie eingezeichnet.

Wie den Diagrammen entnommen werden kann, sind der Wirkungsgrad Eta und die offene Klemmspannung Voc für die Solarzellen mit Zn(O,S)-Pufferschicht für alle S/(S+O)-Verhältnisse kleiner als die entsprechenden Solarparameter für die Solarzelle mit Na-dotierter InS-Pufferschicht. Mit dem höchsten Wert bzw. dem mittleren Wert des S/(S+O)-Verhältnisses der Zn(O,S)-Pufferschicht kann für die Kurzschlussstromdichte Jsc bzw. den Füllfaktor FF jeweils ein annähernd gleicher Wert für die entsprechenden Solarparameter der Solarzelle mit Na-dotierter InS-Pufferschicht erreicht werden. Als Resultat ist festzustellen, dass auch durch eine Veränderung des S/(S+O)-Verhältnisses der Zn(O,S)-Pufferschicht keine ausreichende Verbesserung der Solarparameter erreicht werden kann.

Der Effekt der erfindungsgemäßen Nachbehandlung der Absorberschicht mit und ohne Spülen der Absorberschicht vor Abscheiden der Pufferschicht wird aus Figur 2 ersichtlich. Figur 2 zeigt analog zu Figur 1 die relativen Solarparameter relativer Wirkungsgrad Eta, relative offene Klemmspannung Voc, relative Kurzschlussstromdichte Jsc und relativer Füllfaktor FF für Solarzellen mit verschieden nachbehandelten Absorberschichten mit Zn(O,S)-Puffer, wobei die Absorberschicht einer erfindungsgemäßen Nachbehandlung unterzogen wurde, jeweils bezogen auf eine Zn(O,S)-Pufferschicht, die auf eine nicht nachbehandelte Absorberschicht aufgebracht wurde. Die linken Teildiagramme beziehen sich jeweils auf die Zn(O,S)-Pufferschicht auf einer nichtbehandelten Absorberschicht. Die mittleren Teildiagramme beziehen sich auf Zn(O,S)-Pufferschichten, wobei die Oberfläche der Absorberschicht nach dem Eindiffundieren des Natriumsulfids und vor dem Aufbringen der jeweiligen Zn(O,S)-Pufferschicht einer Oberflächenreinigung unterzogen wurde. Es sind drei verschieden nachbehandelte Absorberschichten mit verschiedenem Na-Gehalt gezeigt, wobei der Na-Gehalt von links nach rechts zunimmt (Na-3 > Na-2 > Na-1). Die rechten Teildiagramme beziehen sich auf verschieden nachbehandelte Absorschichten mit Zn(O,S)-Puffer, wobei die Oberflächen der Absorberschichten vor dem Aufbringen der jeweiligen Zn(O,S)-Pufferschicht nicht gereinigt wurden. Für diesen Fall sind jeweils zwei verschieden nachbehandelte Absorberschichten mit verschiedenem Na-Gehalt gezeigt, wobei der Na-Gehalt von links nach rechts zunimmt (Na-2 > Na-1) .

Aus Figur 2 ist ersichtlich, dass für die kleinste Menge an Natrium (Na-1) in beiden Fällen (mit und ohne Spülen der Absorberschicht) jeweils ein geringer Rückgang des Wirkungsgrades in Bezug auf die Absorberschicht ohne Nachbehandlung auftritt. Erst mit einer größeren Menge an Natrium zeigt sich der vorteilhafte Effekt auf den Wirkungsgrad Eta, sowie die offene Klemmspannung Voc und den Füllfaktor FF. Durch Reinigen der Oberfläche der Absorberschicht kann eine weitere Verbesserung der Solarparameter erreicht werden. Wenn die Oberfläche der Absorberschicht nicht gereinigt wird, kommt es bereits bei Verwendung einer mittleren Menge an Natrium (Na-2) zu einem Rückgang des Füllfaktors FF.

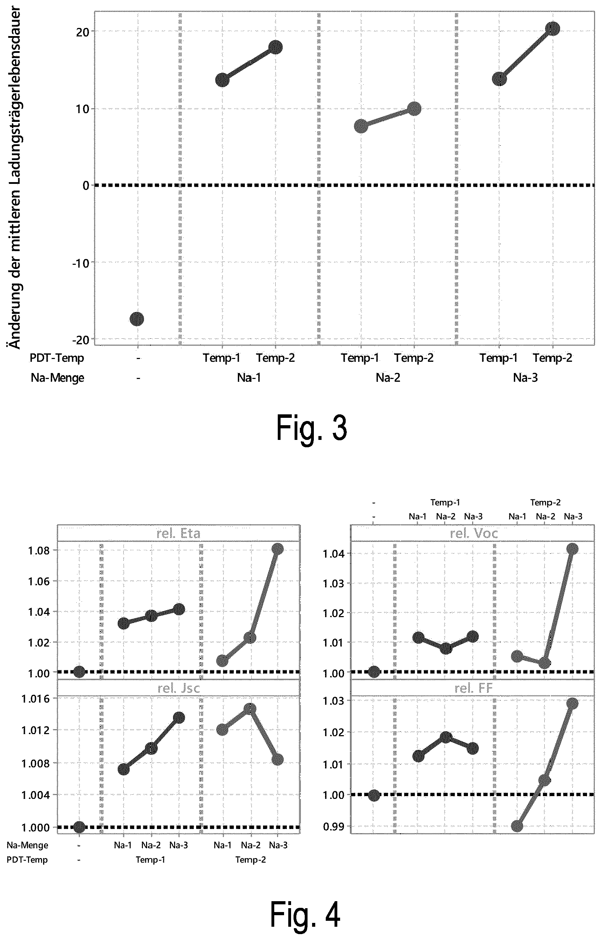

Der Effekt der erfindungsgemäßen Nachbehandlung in der Absorberschicht bzw. an der Grenzfläche Pufferschicht-Absorberschicht lässt sich auch direkt in einer Änderung der mittleren Ladungsträgerlebensdauer aus einer zeitabhängigen Photolumineszenzmessung mit und ohne erfindungsgemäße Nachbehandlung der Absorberschicht nachweisen. Figur 3 zeigt ein Diagramm, in dem die Änderung der mittleren Ladungsträgerlebensdauer nach Aufbringen der Zn(O,S)-Pufferschicht auf die Absorberschicht für drei verschiedene Na-Mengen Na-1 (zweites Teildiagramm von links), Na-2 (drittes Teildiagramm von links) und Na-3 (viertes Teildiagramm von links) dargestellt ist, jeweils bezogen auf die mittlere Ladungsträgerlebensdauer des Schichtensystems ohne Pufferschicht (Absorberschicht + Rückelektrodenschicht + Träger). Als Referenz ist die mittlere Ladungsträgerlebensdauer des Schichtensystems mit Pufferschicht, jedoch ohne erfindungsgemäße Nachbehandlung der Absorberschicht angegeben (erstes Teildiagramm von links). Die Na-Menge nimmt von links nach rechts zu, d.h. es gilt Na-3 > Na-2 > Na-1. Für jede Na-Menge wurde das Eindiffundieren des Nachbehandlungsstoffs bei zwei verschiedenen (Ofen-)Temperaturen Temp-1, Temp-2 durchgeführt, wobei gilt Temp-2 > Temp-1. Die Oberfläche der Absorberschicht wurde gereinigt, bevor die Zn(O,S)-Pufferschicht aufgebracht wurde.

Aus Figur 3 ist ersichtlich, dass die Änderung der mittleren Ladungsträgerlebensdauer ohne erfindungsgemäße Nachbehandlung negativ ist, d.h. die mittlere Ladungsträgerlebensdauer ist nach Aufbringen des Zn(O,S)-Puffers reduziert, wohingegen die Änderung der mittleren Ladungsträgerlebensdauer mit erfindungsgemäßer Nachbehandlung positiv ist, d.h. die mittlere Ladungsträgerlebensdauer ist nach Aufbringen des Zn(O,S)-Puffers auf die nachbehandelte Absorberschicht erhöht. Bei jeweils gleicher Na-Menge tritt mit erfindungsgemäßer Nachbehandlung der Absorberschicht eine Erhöhung der Änderung der Ladungsträgerlebensdauer mit einer Erhöhung der Temperatur beim Eintempern des Nachbehandlungsstoffes auf.

Der erreichbare Wirkungsgrad ist eine Funktion der Alkali-Menge und der Temperatur der Nachbehandlungsschicht beim Eindiffundieren des Nachbehandlungsstoffes in die Absorberschicht. Figur 4 zeigt die relativen Solarparameter relativer Wirkungsgrad Eta, relative offene Klemmspannung Voc, relative Kurzschlussstromdichte Jsc und relativer Füllfaktor FF für Solarzellen mit verschieden nachbehandelten Absorberschichten mit Zn(O,S)-Puffer, jeweils bezogen auf eine Solarzelle mit Zn(O,S)-Puffer, der auf eine nicht erfindungsgemäß nachbehandelte Absorberschicht aufgebracht wird. Die linken Teildiagramme beziehen sich jeweils auf eine Zn(O,S)-Pufferschicht, die auf eine nicht nachbehandelte Absorberschicht aufgebracht wurde. Die mittleren Teildiagramme beziehen sich auf Zn(O,S)-Pufferschichten, wobei die Oberfläche der Absorberschicht nach dem Eindiffundieren des Natriumsulfids und vor dem Aufbringen der jeweiligen Zn(O,S)-Pufferschicht einer Oberflchenreinigung unterzogen wurde. Es sind drei verschieden nachbehandelte Absorberschichten mit Zn(O,S)-Puffer mit verschiedenem Na-Gehalt (aus dem Natriumsulfid stammend) gezeigt, wobei der Na-Gehalt von links nach rechts zunimmt (Na-3> Na-2> Na-1). In den mittleren Teildiagrammen wurde die Nachbehandlung der Absorberschicht bei einer Temperatur Temp-1 durchgeführt. Die rechten Teildiagramme beziehen sich auf Zn(O,S)-Pufferschichten, wobei die Oberfläche der Absorberschicht nach dem Eindiffundieren von Natriumsulfid und vor dem Aufbringen der jeweiligen Zn(O,S)-Pufferschicht einer Oberflächenreinigung unterzogen wurde. Es sind drei verschieden nachbehandelte Absorberschichten mit verschiedenem Na-Gehalt gezeigt, wobei der Na-Gehalt von links nach rechts zunimmt (Na-3 > Na-2 > Na-1). In den rechten Teildiagrammen wurde die Nachbehandlung der Absorberschicht bei einer Temperatur Temp-2 durchgeführt, wobei gilt Temp-2 > Temp-1.

Die Verbesserung des Wirkungsgrades einer Solarzelle mit Zn(O,S)-Pufferschicht durch die erfindungsgemäße Nachbehandlung der Absorberschicht zeigt sowohl eine Abhängigkeit von der Alkali-Menge als auch der verwendeten Temperatur während der Nachbehandlung (Trägertemperatur, Temperatur des Ofens). Es ist keine Sättigung des Effektes der Nachbehandlung erkennbar; eine Erhöhung der Temperatur mit Erhöhung der Na-Menge scheint besonders vorteilhaft.

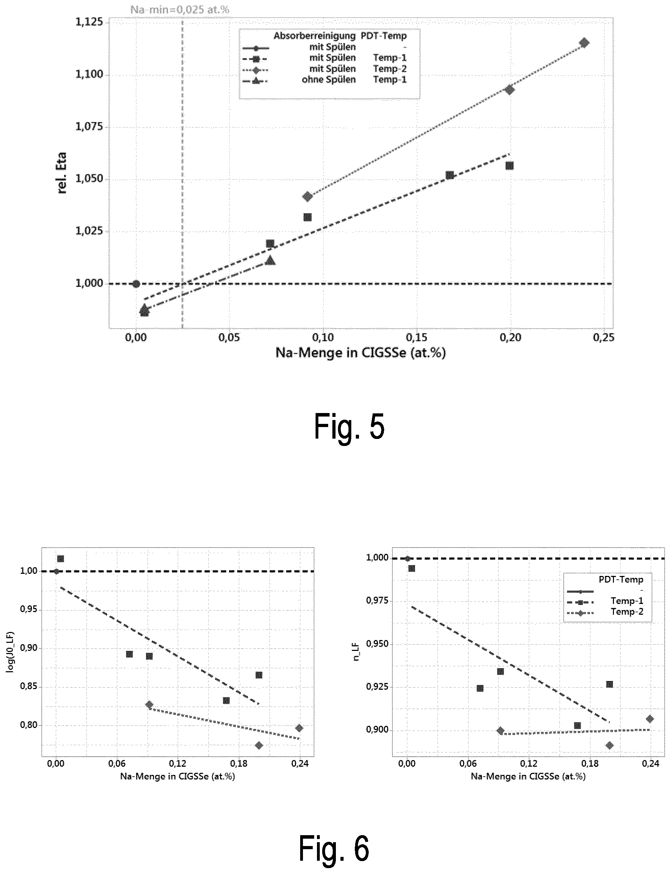

In Figur 5 ist der Einfluss der Na-Menge auf den relativen Wirkungsgrad Eta gezeigt. Dargestellt sind veschiedene Messwerte für eine Solarzelle mit einer Zn(O,S)-Pufferschicht, die auf eine erfindungsgemäß nachbehandelte Absorberschicht aufgebracht wurde, wobei die Absorberschicht vor dem Aufbringen gereinigt oder nicht gereinigt wurde. Als Referenz (horizontale Linie bei relativem Wirkungsgrad rel. Eta = 1) diente eine Solarzelle mit Zn(O,S)-Pufferschicht, die auf eine nicht erfindungsgemäß nachbehandelte Absorberschicht aufgebracht wurde, wobei die Absorberschicht vor dem Aufbringen der Zn(O,S)-Pufferschicht in gleicher Weise gereinigt wurde. Wie in Figur 5 gezeigt, kann schon durch eine Alkali-Menge von mindestens 0,02 Atom-% in der Absorberschicht eine Verbesserung des Wirkungsgrads erreicht werden.

Figur 6 zeigt relative Sekundärsolarparameter (Sättigungsstromdichte J0 und Diodenidealitätsfaktor n) für Solarzellen mit Zn(O,S)-Puffer ohne erfindungsgemäße Nachbehandlung sowie mit erfindungsgemäßer Nachbehandlung der Absorberschicht für verschiedene Na-Mengen, sowie drei verschiedene Nachbehandlungstemperaturen Temp-1, Temp-2 und Temp-3, wobei Temp-3 > Temp-2 > Temp-1 gilt. Vor Abscheidung der Zn(O,S)-Pufferschichten wurde die Oberfläche der Absorberschicht jeweils gereinigt. Sättigungsstromdichte und Diodenidealitätsfaktor wurden durch Modellierung der gemessenen I-V Kennlinie nach dem 1-Diodenmodell gewonnen. Hohe Werte dieser Sekundärsolarparameter weisen auf eine verstärkte Rekombination im Bereich des Absorber-Puffer-Übergangs hin. Durch die erfindungsgemäße Nachbehandlung der Absorberschicht wird die Rekombination der Ladungsträger im Bereich des Absorber-Puffer-Übergangs erheblich reduziert.

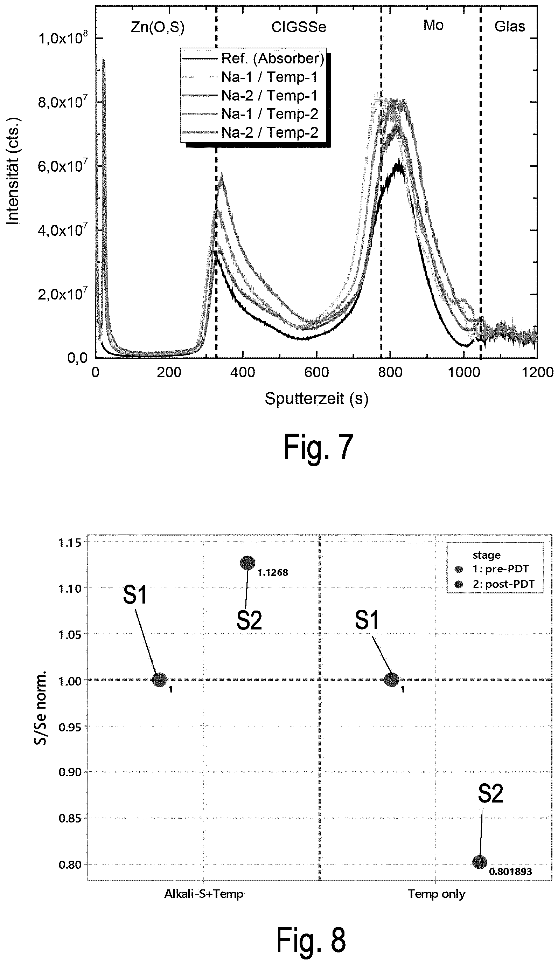

Figur 7 zeigt TOF-SIMS Na-Profile von Pufferschicht und Absorberschicht ohne erfindungsgemäße Nachbehandlung der Absorberschicht sowie mit erfindungsgemäßer Nachbehandlung der Absorberschicht für zwei verschiedene Na-Mengen N-1 und Na-2, wobei Na-2 > Na-1 gilt, sowie für zwei verschiedene Nachbehandlungstemperaturen Temp-1 und Temp-2, wobei Temp-2 > Temp-1 gilt. Die Signalintensität ist gegen die Sputterzeit aufgetragen.

Demnach zeigt sich ein Anwachsen der Na-Menge im Grenzflächenbereich Pufferschicht-Absorberschicht mit wachsender Na-Menge und/oder Temperatur, welches sich bis weit in die Absorbertiefe hineinzieht. Auch am Übergang der CIGSSe-Absorberschicht zum Molybdän-basierten Rückkontakt zeigt sich eine Erhöhung des Na-Signals in TOF-SIMS gegenüber der Referenzschicht, allerdings scheint hier der Einbau eher getrieben von der Löslichkeit des Natriums in den beteiligten Schichten, da sich wenig Abhängigkeit von Na-Menge und/oder Temperatur der Nachbehandlung der Absorberschicht zeigt.

Die Absorberschicht weist nach Aufbringen und Eintempern des Nachbehandlungsstoffes, ohne eine Reinigung der Absorberoberfläche, verschiedene weitere Eigenschaften auf.

Figur 8 zeigt das Oberflächen-S-korrelierte Raman-Signal für CIGSSe-Absorberoberflächen. "Stage 1" bezieht sich auf den Zustand vor der erfindungsgemäßen Nachbehandlung, "Stage 2" auf den Zustand nach der erfindungsgemäßen Nachbehandlung bzw. nach Tempern der Absorberschicht. Die Messpunkte für Stage 1 sind mit "S1", die Messpunkte für Stage 2 mit "S2", gekennzeichnet.

Demnach zeigt das Oberflächen-S-korrelierte Raman-Signal für die Absorberschicht mit Alkalisulfid-Aufbringung und Eintempern einen deutlichen Anstieg von 13%_rel im Vergleich zu einer in vergleichbarer Atmosphäre (Vakuum) getemperten Absorberschicht ohne Alkalisulfid, die 20%_rel des Raman-Signals verliert, jeweils in Bezug auf die Signalintensität der Absorberoberfläche vor erfindungsgemäßer Nachbehandlung bzw. Tempern.

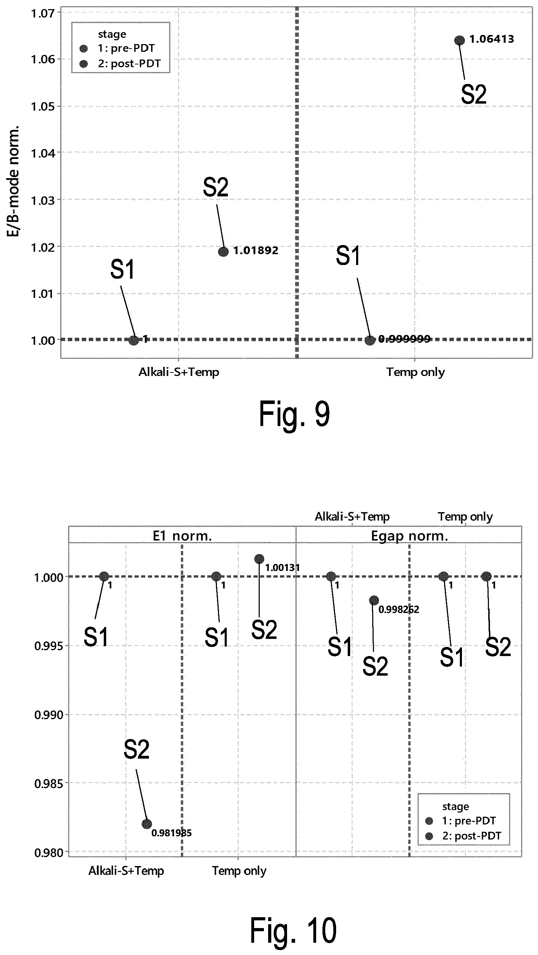

Figur 9 zeigt das CIG-korrelierte Raman-Signal für CIGSSe-Absorberoberflächen. "Stage 1" bezieht sich auf den Zustand vor der erfindungsgemäßen Nachbehandlung, "Stage 2" auf den Zustand nach erfindungsgemäßer Nachbehandlung bzw. nach Tempern. Die Messpunkte für Stage 1 sind mit "S1", die Messpunkte für Stage 2 mit "S2", gekennzeichnet.

Demnach zeigt das Oberflächen-CIG-Verhältnis-korrelierte Raman-Signal für die Absorberschicht mit Alkalisulfid-Nachbehandlung weniger Änderung als für die nur getemperte Absorberschicht. Ein Anstieg des Raman-Signals wäre ein Hinweis für einen Anstieg des oberflächlichen Cu/In+Ga (CIG) Verhältnisses.

Figur 10 zeigt eine Reflektometrie-Auswertung für CIGSSe-Absorberoberflächen. "E1" entspricht einem Peak im Reflektionsspektrum, der mit der Oberflächenbandlücke korreliert, die durch den S/Se Anteil in diesen Absorbern bestimmt ist. "Egap" entspricht der minimalen Bandlücke in der Absorbertiefe. "Stage 1" bezieht sich auf den Zustand vor der erfindungsgemäßen Nachbehandlung, "Stage 2" auf den Zustand nach erfindungsgemäßer Nachbehandlung bzw. nach Tempern. Die Messpunkte für Stage 1 sind mit "S1", die Messpunkte für Stage 2 mit "S2", gekennzeichnet.

Demnach zeigt das E1-Signal aus der Reflektometrie (Korrelation mit der Oberflächenbandlücke des Absorbers) für den Absorber mit Alkalisulfid-Nachbehandlung eine deutliche Reduktion der Oberflächenbandlücke, während der nur getemperte Absorber eine unveränderte Oberflächenbandlücke aufweist, jeweils in Bezug auf den Zustand vor Nachbehandlung bzw. Tempern.

Die Absorberschicht weist nach Aufbringen und Eintempern des Nachbehandlungsstoffes, nach dem zusätzlichen Reinigungsschritt der Absorberoberfläche, z.B. mittels Spülen, verschiedene weitere Eigenschaften auf.

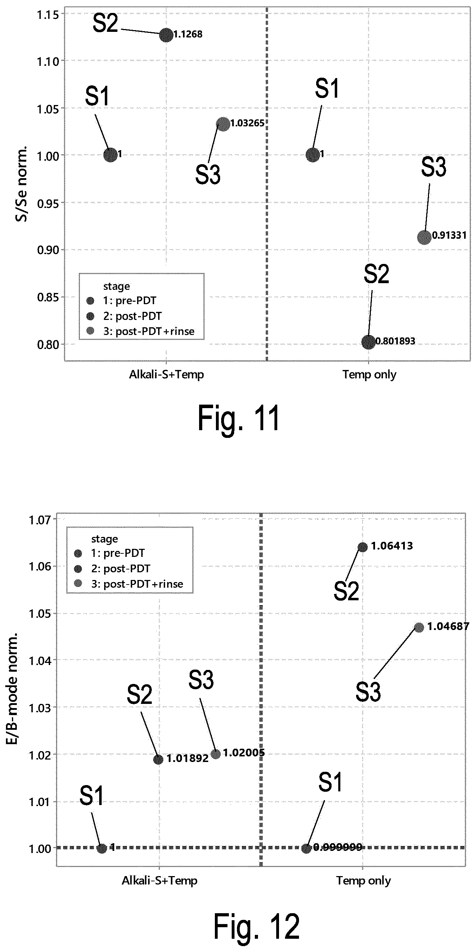

Figur 11 zeigt das Oberflächen-S-korrelierte Raman-Signal für CIGSSe-Absorberoberflächen. "Stage 1" bezieht sich auf den Zustand vor der erfindungsgemäßen Nachbehandlung, "Stage 2" auf den Zustand nach erfindungsgemäßer Nachbehandlung bzw. nach Tempern, "Stage 3" auf den Zustand nach Alkalisulfid-Nachbehandlung bzw. nach Tempern und zusätzlichem Reinigungsschritt der Absorberoberfläche. Die Messpunkte für Stage 1 sind mit "S1", die Messpunkte für Stage 2 mit "S2", die Messpunkte für Stage 3 mit "S3", gekennzeichnet.

Demnach zeigt das Oberflächen-S-korrelierte Raman-Signal für den Absorber mit Alkalisulfid-Aufbringung und Eintempern auch nach dem Reinigungsschritt der Absorberoberfläche einen Anstieg im Vergleich zu einem in vergleichbarer Atmosphäre (Vakuum) getemperten Absorber ohne Alkalisulfid, jeweils in Bezug auf die Signalintensität der Absorberoberfläche vor Nachbehanldung bzw. Tempern.

Figur 12 zeigt das CIG-korrelierte Raman-Signal für CIGSSe-Absorberoberflächen. "Stage 1" bezieht sich auf den Zustand vor der erfindungsgemäßen Nachbehandlung, "Stage 2" auf den Zustand nach erfindungsgemäßer Nachbehandlung bzw. nach Tempern, "Stage 3" auf den Zustand nach Alkalisulfid-Nachbehandlung bzw. nach Tempern und zusätzlichem Reinigungsschritt der Absorberoberfläche. Die Messpunkte für Stage 1 sind mit "S1", die Messpunkte für Stage 2 mit "S2", die Messpunkte für Stage 3 mit "S3", gekennzeichnet.

Demnach zeigt das Oberflächen-CIG-Verhältnis-korrelierte Raman-Signal nach dem zusätzlichen Reinigungsschritt der Absorberoberfläche keine Änderung für den Absorber mit Alkalisulfid-Nachbehandlung; beim nur getemperten Absorber ist ein leichter Rückgang des Raman-Signals zu verzeichnen. Insgesamt zeigt sich damit für den Absorber mit Alkalisulfid-Nachbehandlung kein anderes oberflächliches CIG-Verhältnis als beim nur getemperten Absorber.

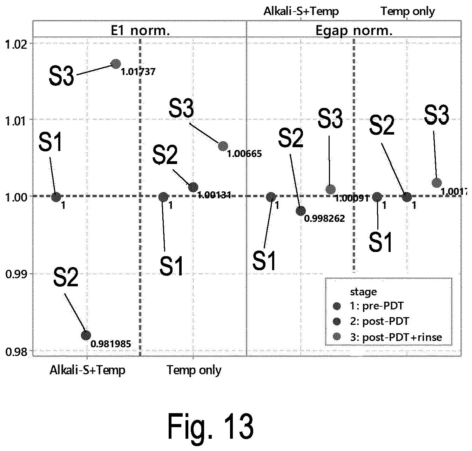

Figur 13 zeigt eine Reflektometrie-Auswertung für CIGSSe Absorberoberflächen. "E1" entspricht einem Peak im Reflektionsspektrum, der mit der Oberflächenbandlücke korreliert, die durch den S/Se Anteil in diesen Absorbern bestimmt ist. "Egap" entspricht der minimalen Bandlücke in der Absorbertiefe. "Stage 1" bezieht sich auf den Zustand vor der erfindungsgemäßen Nachbehandlung, "Stage 2" auf den Zustand nach erfindungsgemäßer Nachbehandlung bzw. nach Tempern, "Stage 3" auf den Zustand nach Alkalisulfid-Nachbehandlung bzw. nach Tempern und zusätzlichem Reinigungsschritt der Absorberoberfläche. Die Messpunkte für Stage 1 sind mit "S1", die Messpunkte für Stage 2 mit "S2", die Messpunkte für Stage 3 mit "S3", gekennzeichnet.

Demnach zeigt das E1-Signal aus der Reflektometrie (Korrelation mit der Oberflächenbandlücke des Absorbers) für den Absorber mit Alkalisulfid-Nachbehandlung erst durch den zusätzlichen Reinigungsschritt der Absorberoberfläche einen deutlichen Anstieg der Oberflächenbandlücke, während der nur getemperte Absorber auch nach dem Reinigungsschritt eine unveränderte Oberflächenbandlücke aufweist, jeweils in Bezug auf den Zustand vor Nachbehandlung bzw. Tempern.

Nur durch die erfindungsgemäße Verwendung eines S-haltigen Nachbehandlungsstoffes kann im Falle der sulfoselenidischen Oberfläche des sequentiellen Absorbers eine S-Verarmung der Absorberoberfläche im Nachbehandlungsprozess verhindert werden. Analog kann hieraus gefolgert werden, dass im Falle eines Absorbers mit einer rein selenidischen Oberfläche ein Se-haltiger Nachbehandlungsstoff verwendet werden muss, um eine Se-Verarmung der Absorberoberfläche im Nachbehandlungsprozess zu unterbinden.

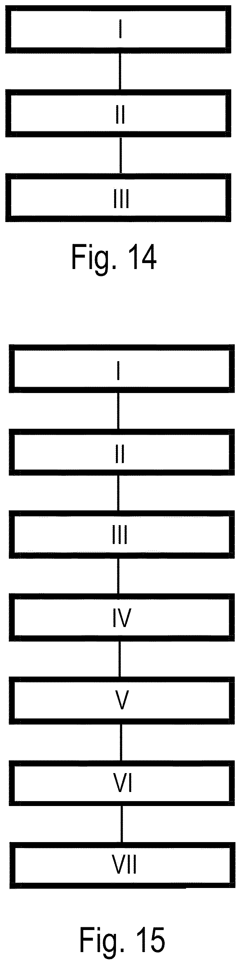

In Figur 14 ist das Verfahren zur Nachbehandlung einer Absorberschicht eines Schichtensystems für die Fertigung von Dünnschichtsolarzellen anhand eines Ablaufdiagramms schematisch veranschaulicht. Zunächst wird in einem ersten Schritt I eine chalkogenhaltige Absorberschicht auf einem Träger bereitgestellt. Anschließend wird in einem zweiten Schritt II eine Nachbehandlungssschicht auf eine Oberfläche der Absorberschicht aufgebracht, wobei die Nachbehandlungsschicht mindestens einen Nachbehandlungsstoff, gewählt aus der Gruppe, bestehend aus einem Metallchalkogenid, einer Sauerstoffverbindung eines Metallchalkogenids und einer Hydrogen-Sauerstoffverbindung eines Metallchalkogenids, enthält. Dann wird in einem dritten Schritt III der mindestens einen Nachbehandlungsstoff in die Absorberschicht thermisch eindiffundiert. Vorzugsweise erfolgt in einem optionalen vierten Schritt IV eine Reinigung der Absorberoberfläche.

In Figur 15 ist das Verfahren zur Herstellung eines Schichtensystems für die Fertigung von Dünnschichtsolarzellen, in dem die Absorberschicht erfindungsgemäß nachbehandelt wird, anhand eines Ablaufdiagramms schematisch veranschaulicht. Zunächst wird in einem ersten Schritt I ein Träger bereitgestellt. In einem zweiten Schritt II wird eine Rückelektrodenschicht auf dem Träger hergestellt. In einem dritten Schritt III wird eine chalkogenhaltige Absorberschicht auf der Rückelektrodenschicht hergestellt. In einem vierten Schritt IV wird eine Nachbehandlungssschicht auf eine Oberfläche der Absorberschicht aufgebracht, wobei die Nachbehandlungsschicht mindestens einen Nachbehandlungsstoff, gewählt aus der Gruppe, bestehend aus einem Metallchalkogenid, einer Sauerstoffverbindung eines Metallchalkogenids und einer Hydrogen-Sauerstoffverbindung eines Metallchalkogenids, enthält. Dann wird in einem fünften Schritt V der mindestens eine Nachbehandlungsstoff in die Absorberschicht thermisch eindiffundiert. In einem sechsten Schritt VI wird mindestens eine Pufferschicht auf der Absorberschicht hergestellt. Schließlich wird in einem siebten Schritt VII eine Frontelektrodenschicht auf der Pufferschicht hergestellt. Vorzugsweise erfolgt in einem optionalen Schritt eine Reinigung der Absorberoberfläche nach dem Eindiffundieren des mindestens einen Nachbehandlungsstoffes und vor dem Aufbringen der Pufferschicht auf die Absorberschicht.

Aus den vorstehenden Ausführungen ergibt sich, dass durch die erfindungsgemäße Nachbehandlung der Absorberschicht in vorteilhafter Weise eine Verbesserung von Solarmodulparametern, insbesondere des Wirkungsgrads, von Dünnschichtsolarmodulen erreicht werden kann. Der Nachbehandlungsstoff hat eine Doppelfunktion und dient zugleich als Lieferant für das Alkalimetall für eine Alkalipassivierung der Absorberschicht wie auch als Lieferant für das Chalkogen für eine Oberflächenterminierung der Absorberschicht, insbesondere Se für rein selenidische Koverdampfungsabsorber und S für gemischt sulfo-selenidische sequentielle Absorber. Die nachbehandelte Absorberschicht macht die Verwendung von Pufferschichten auf Basis von Zn(O,S) wirtschaftlich sinnvoll einsetzbar und ermöglicht hierdurch insbesondere die Verwendung eines Vakuumverfahrens zur Abscheidung der Pufferschicht. Dies erleichtert wesentlich die Herstellung der Pufferschicht und verringert die Kosten der Herstellung des Schichtensystems. Zudem werden ökologische Vorteile erzielt.

## Patentansprüche

1. Verfahren zur Nachbehandlung einer Absorberschicht für die fotoelektrische Konversion von einfallendem Licht in elektrischen Strom, welches die folgenden Schritte umfasst:
- Bereitstellen einer chalkogenhaltigen Absorberschicht auf einem Träger;
- Aufbringen einer Nachbehandlungssschicht auf eine Oberfläche der Absorberschicht, wobei die Nachbehandlungsschicht mindestens einen Nachbehandlungsstoff, gewählt aus der Gruppe, bestehend aus einem Metallchalkogenid, einer Sauerstoffverbindung eines Metallchalkogenids und einer Hydrogen-Sauerstoffverbindung eines Metallchalkogenids, enthält;
- thermisches Eindiffundieren des mindestens einen Nachbehandlungsstoffs in die Absorberschicht.

2. Verfahren nach Anspruch 1, bei welchem der Nachbehandlungsstoff gewählt ist aus der Gruppe bestehend aus einem Alkalisulfid, insbesondere Na₂S, K₂S, Rb₂S, Cs₂S, einem Erdalkalisulfid insbesondere MgS, CaS, einer Hydrogen-Sauerstoffverbindung eines Metallchalkogenids mit der Oxidationsstufe IV, insbesondere NaHSO₃, KHSO₃, RbHSO₃, CsHSO₃, einer Sauerstoffverbindung eines Metallchalkogenids mit der Oxidationsstufe IV, insbesondere Na₂SO₃, K₂SO₃, Rb₂SO₃, Cs₂SO₃, einer Hydrogen-Sauerstoffverbindung eines Metallchalkogenids mit der Oxidationsstufe VI, insbesondere NaHSO₄, KHSO₄, RbHSO₄, CsHSO₄, und einer Sauerstoffverbindung eines Metallchalkogenids mit der Oxidationsstufe VI, insbesondere Na₂SO₄, K₂SO₄, Rb₂SO₄, Cs₂SO₄.

3. Verfahren nach einem der Ansprüche 1 bis 2, bei welchem die Absorberschicht nach dem Eindiffundieren des mindestens einen Nachbehandlungsstoffs in die Absorberschicht einen Stoffmengenanteil an Metall im Bereich von 0,02 Atom-% bis 2,5 Atom-%, insbesondere im Bereich 0,1 Atom-% bis 1,3 Atom-%, bezogen auf die Gesamtstoffmenge der Absorberschicht, aufweist.

4. Verfahren nach einem der Ansprüche 1 bis 3, bei welchem für die Herstellung der Nachbehandlungsschicht genau ein Nachbehandlungsstoff mit genau einem Alkalichalkogenid, genau einer Sauerstoffverbindung eines Alkalichalkogenids oder genau einer Hydrogen-Sauerstoffverbindung eines Alkalichalkogenids auf die Absorberschicht aufgebracht wird, wobei im Nachbehandlungsstoff nur ein einziges Alkalielement chemisch gebunden ist.

5. Verfahren nach einem der Ansprüche 1 bis 4, bei welchem mindestens ein Nachbehandlungsstoff auf der Absorberschicht durch thermisches Verdampfen, nasschemische Badabscheidung, Elektronenstrahlverdampfung, Sputtern, Atomic Layer Deposition oder Sprühpyrolyse abgeschieden wird.

6. Verfahren nach einem der Ansprüche 1 bis 5, bei welchem für das Eindiffundieren des mindestens einen Nachbehandlungsstoffs in die Absorberschicht die Nachbehandlungsschicht erwärmt wird.

7. Verfahren nach Anspruch 6, bei welchem die Nachbehandlungsschicht auf eine Temperatur im Bereich von 70°C bis 700°C, insbesondere im Bereich von 150°C bis 700°C, bei einer Heizdauer im Bereich von 1 min bis 120 min, erwärmt wird.

8. Verfahren nach Anspruch 6, bei welchem die Nachbehandlungsschicht mit einem Energieeintrag im Bereich von 0,5 J/cm² bis 15 J/cm², insbesondere bei einer Pulsdauer im Bereich von 0,2 msec bis 20 msec, erwärmt wird.

9. Verfahren nach einem der Ansprüche 1 bis 8, bei welchem die Absorberschicht beim Aufbringen der Nachbehandlungsschicht eine Temperatur im Bereich von 300°C bis 800°C aufweist.

10. Verfahren nach einem der Ansprüche 1 bis 9, bei welchem das Eindiffundieren des mindestens einen Nachbehandlungsstoffs in die Absorberschicht in einer evakuierten Umgebung erfolgt.

11. Verfahren nach einem der Ansprüche 1 bis 9, bei welchem das Eindiffundieren des mindestens einen Nachbehandlungsstoffs in die Absorberschicht in einer mindestens ein Chalkogen enthaltenden Atmosphäre oder in einer chalcogenfreien Atmosphäre, insbesondere Inertgas, erfolgt.

12. Verfahren nach einem der Ansprüche 1 bis 11, bei welchem die Oberfläche der Absorberschicht nach dem Eindiffundieren des Nachbehandlungsstoffs in die Absorberschicht durch physikalische und/oder chemische, trockene und/oder nasse Reinigungsprozesse, insbesondere durch Spülen mit einem gasförmigen oder flüssigen Fluid und/oder Bestrahlen mit UV-Licht und/oder mittels Plasma gereinigt wird.

13. Verfahren zur Herstellung eines Schichtensystems für die Fertigung von Dünnschichtsolarzellen, welches umfasst:
- Bereitstellen eines Trägers,
- Herstellen einer Rückelektrodenschicht auf dem Träger,
- Herstellen einer chalkogenhaltigen Absorberschicht auf der Rückelektrodenschicht,
- Herstellen mindestens einer Pufferschicht auf der chalkogenhaltigen Absorberschicht,
- Herstellen einer Frontelektrodenschicht auf der Pufferschicht,
wobei die chalkogenhaltige Absorberschicht einer Nachbehandlung nach einem der Patentansprüche 1 bis 12 unterzogen wird.

14. Verfahren nach Anspruch 13, bei welchem die Pufferschicht in einer evakuierten Umgebung, insbesondere durch Sputtern, abgeschieden wird.

15. Verwendung des Verfahrens zur Nachbehandlung einer Absorberschicht nach einem der Ansprüche 1 bis 12 bei der Herstellung eines Schichtensystems für Dünnschichtsolarzellen.
